Europäisches Patentamt

European Patent Office

Office européen des brevets

(11) Numéro de publication:

**0 065 465**
A1

## (12) DEMANDE DE BREVET EUROPEEN

(21) Numéro de dépôt: 82400878.3

(22) Date de dépôt: 11.05.82

(51) Int. Cl.³: **G 03 C 7/12,** H 01 L 31/02

(30) Priorité: 19.05.81 FR 8109936

(43) Date de publication de la demande: 24.11.82
Bulletin 82/47

(84) Etats contractants désignés: DE GB NL

(71) Demandeur: THOMSON-CSF, 173, Boulevard Haussmann, F-75379 Paris Cedex 08 (FR)

(72) Inventeur: Galves, Jean-Pierre, THOMSON-CSF SCPI 173, bld Haussmann, F-75379 Paris Cedex 08 (FR)
Inventeur: Gomez, Gérard, THOMSON-CSF SCPI 173, bld Haussmann, F-75379 Paris Cedex 08 (FR)

(74) Mandataire: Mayeux, Michèle et al, THOMSON-CSF SCPI 173, Bld Haussmann, F-75379 Paris Cedex 08 (FR)

(54) Procédé de réalisation d'un filtre coloré pour photosenseur.

(57) Afin de permettre la réalisation de filtres colorés en couches minces pour photosenseurs, l'invention prévoit l'utilisation de résines appliquées directement sur le plan optique du photosenseur, et douées de la double propriété d'être capables de fixer les colorants et d'être rendues résistantes à l'action des solvants par exposition à la lumière; ainsi sont créées, dans une même épaisseur, sur le support, les bandes contiguës 2, 4, 5 constitutives du filtre. Les résines sont notamment des solutions d'alcool polyvinylique et de gélatine. Parmi les colorants, un bleu, un rouge, et un vert sont utilisés pour la constitution des ensembles tricolores habituellement pratiqués. Un couple de couleurs bleu, magenta peut permettre, dans certaines conditions, d'obtenir le même résultat. Application aux photosenseurs à l'état solide pour caméras de télévision.

EP 0 065 465 A1

# PROCEDE DE REALISATION D'UN FILTRE COLORE POUR PHOTOSENSEUR.

L'invention concerne la réalisation d'un filtre coloré pour photosenseur.

Les photosenseurs, ou capteurs, réalisés, en particulier, à l'état solide dans une plaquette d'un matériau semi-conducteur, élaborent point par point une image du rayonnement incident ; cette image est lue par des techniques diverses, dont celle, notamment, du transfert de charges, citée à titre indicatif ; cette technique utilise, comme on sait, le transfert de proche en proche des charges porteuses du signal au sein d'un matériau semi-conducteur qui ne fait généralement qu'un avec la plaquette précédente.

Lorsque, de plus, on veut obtenir d'un même capteur des points de couleur, c'est-à-dire pour chaque point des informations de chrominance, en bleu, vert et rouge, utilisées à la synthèse de cette couleur, il est nécessaire de procéder, lors de la prise de vues, à la décomposition, en chaque point, en trois composantes aux couleurs indiquées.

Cette décomposition est obtenue, de façon usuelle, par l'intermédiaire d'un filtre appliqué sur le plan optique du photosenseur, c'est-à-dire le plan de l'image formée sur celui-ci par le rayonnement. Ce filtre comprend, pour chaque point image, trois zones contiguës possédant des caractéristiques de transmission spectrale différentes. Les zones contiguës, uniformément colorées, peuvent avoir des formes diverses, dont les plus courantes sont celles de bandes ou de pavés disposés suivant une mosaïque. L'invention s'applique, de façon générale, à de tels filtres, quelle que soit la forme de ces zones ; on considérera dans ce qui suit, cependant, pour fixer les idées, le cas de bandes, sans que ceci puisse être considéré, à un titre quelconque, comme limitatif de l'invention.

La structure des photosenseurs à l'état solide, tels qu'on les connaît actuellement conduit à retenir la dimension de 10 à 30 micromètres : largeur des bandes dans le cas de filtres à bandes, côté du pavé, dans le cas de mosaïques de pavés sensiblement carrés, pour s'en tenir aux exemples cités .

D'autre part, pour des raisons de résolution de l'image, l'épaisseur des parties actives du filtre, c'est-à-dire celle de ces zones, ne doit pas excéder 3 micromètres, tout en permettant un filtrage suffisant des couleurs. Ce sont ces ordres de grandeurs que l'on considérera dans la suite.

On a proposé, dans l'art antérieur, diverses méthodes d'obtention de ces filtres. On rappelle ci-dessous quelques unes d'entre elles.

D'une façon générale, ces méthodes comme celle de l'invention, utilisent, comme matériau actif de ces filtres, une résine, ou résine matrice, colorée aux couleurs désirées.

Une première méthode de l'art antérieur utilise la technique des réserves photographiques, suivant laquelle le colorant est fixé à la résine matrice au travers d'un masque, lui-même fait de résine, à savoir une résine photosensible ; selon une technique bien connue, et appliquée notamment en micro-électronique, il est aisé avec de telles résines, photosensibles, de réaliser par insolation et solubilisation de certaines de leurs parties dans des agents chimiques, des masques ; ce sont ces masques qui, appliqués sur la résine matrice, permettent de teinter celle-ci dans des zones préférentielles, à la couleur choisie. L'opération est répétée autant de fois qu'il y a de couleurs à appliquer.

Une telle méthode exige l'application pour chaque couleur d'une couche de résine photosensible, puis son traitement pour lui conférer les propriétés d'un masque, et enfin son élimination totale avant l'opération suivante ; ces opérations sont longues et laborieuses ; de plus, la diffusion latérale des colorants entraîne une mauvaise résolution en couleurs, et oblige enfin, pratiquement, à toujours prévoir des filtres préparés séparement puis mis en position ensuite sur le photosenseur. On consultera à son sujet les deux brevets français 2.367.391 et 2.367.392 (N° d'enregistrement national 77.30189 et 77.30190 respectivement).

Une autre méthode de l'art antérieur utilise des colorants blanchissables, contenus dans la résine matrice, qui sont détruits sélectivement par exposition à la lumière, à travers des masques doués de caractéristiques de filtrage adaptées aux couleurs et au dessin du filtre à obtenir. Cette méthode conduit à des épaisseurs de résine matrice qui généralement dépassent sensiblement les 3 micromètres indiqués et, en plus, à un temps d'exposition, pour chaque couleur, de l'ordre de l'heure, peu praticable industriellement (voir le brevet français 2.415.825 et le certificat d'utilité français 2.199.190 auxquels correspondent les numéros d'enregistrement national 79.02253 et 73.32399.

Une autre méthode, encore, consiste, suivant l'art antérieur, à réaliser les bandes d'une couleur par une technique connue comme par exemple celle du premier art antérieur cité, puis à les recouvrir d'une couche protectrice neutre du point de vue spectral, avant la réalisation de la série de bandes suivantes (voir le brevet français 2.449.974 n° 80.04179). Cette méthode conduit à une épaisseur totale peu compatible avec la profondeur de champ des optiques habituellement utilisées pour former l'image sur le senseur, et à une résolution insuffisante.

Pour éviter les inconvénients précédents, le procédé de l'invention utilise une résine matrice servant à la fois, contrairement au cas de l'art antérieur, de matériau de réserve et de matériau accepteur de colorant, dans les conditions qui vont être exposées. Il est ainsi possible d'obtenir un filtre en couche mince favorable à une bonne résolution de l'image.

L'invention concerne un procédé de réalisation d'un filtre coloré pour photosenseur recevant sur une de ses faces l'image d'un rayonnement, composé de zones colorées exposées à ce dernier, obtenu par insolation et élimination sélective par un solvant de parties de couches de résine appliquées sur cette face, puis teinture des parties restantes par des colorants, à des couleurs déterminées, caractérisé en ce que ces résines sont appliquées directement sur cette face et en ce que elles sont douées de la double propriété d'être rendues solubles (ou insolubles) par exposition à la lumière, et d'accepter la coloration par lesdits colorants.

Le procédé de l'invention sera décrit, pour la commodité, dans le cas d'une préparation séparée du filtre, mis ensuite en place sur la plaquette de semi-conducteur dans laquelle sont réalisés les photosenseurs correspondants aux différents points de l'image. Puis on précisera l'adaptation à lui faire subir dans le cas d'une préparation "in situ", sur la plaquette de semi-conducteur elle-même. En fait, dans la plupart de ses variantes, il est intégralement applicable à ce dernier cas.

L'invention sera mieux comprise en se reportant à la description qui suit et aux figures jointes qui représentent :

- figure 1 : un ensemble de vues en coupe montrant une suite d'opérations du procédé de préparation d'un filtre coloré de l'invention ;

- figure 2 : un ensemble analogue d'une autre suite d'opérations du même procédé ;

- figures 3 et 4 : des vues concernant des variantes de certaines des opérations précédentes ;

- figures 5 et 6 : des vues concernant des variantes de certaines opérations du procédé de l'invention, dans un autre exemple d'application ;

- figure 7 : une vue explicative en rapport avec la figure 6.

La partie active du filtre est constituée d'une résine gravée puis teintée.

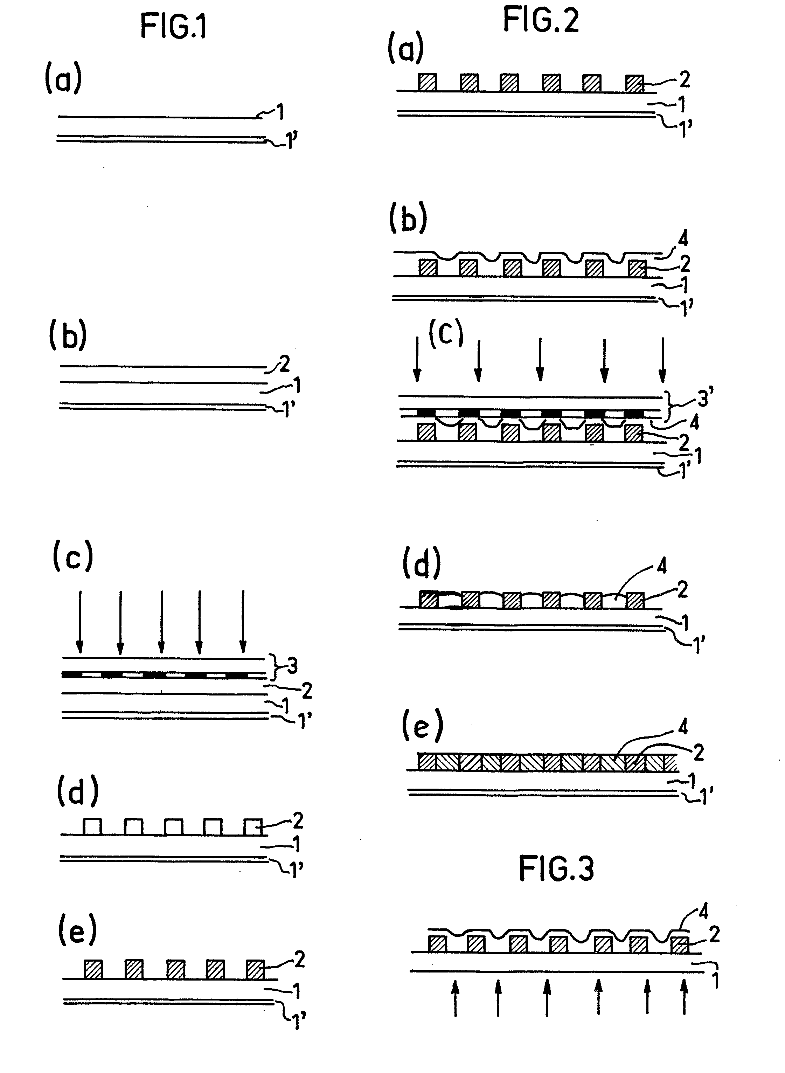

Les figures 1 montrent les différentes étapes du procédé de préparation de l'invention.

Le filtre est préparé sur un substrat de verre 1, nommé verre pelliculaire, en forme de lame à faces parallèles ; ce verre est transparent à la lumière et a une épaisseur aussi faible que possible. Cette épaisseur est choisie cependant suffisante pour permettre une découpe et une manipulation aisée sans risque de rupture ; une épaisseur de 100 micromètres est un bon compromis. Sur l'une des faces de la lame est appliquée la résine, tandis que la face opposée est revêtue d'un film 1', fait d'un vernis pelliculable qui assure un effet anti-halo lors des insolations de la résine.

La première opération consiste dans le dépôt du vernis pelliculable sur le verre pelliculaire, le résultat à obtenir au cours de cette opération étant un bon contact optique du premier sur le second et une bonne densité optique du vernis dans le spectre de la lumière d'insolation utilisée pour réaliser le filtre ; la densité optique d'un matériau est définie comme le cologarithme du rapport de l'intensité d'un faisceau incident dirigé sur le matériau - ici l'intensité d'insolation - à l'intensité du faisceau après traversée du matériau. Le trempage allie de façon satisfaisante ces deux conditions. Le vernis utilisé est, par exemple, le vernis Stripcover, jaune, RLM 17017, marque déposée de la Société Blancomme ; il est teinté avec une base colorante noire du même fournisseur. L'ensemble se présente en coupe comme l'indique la figure 1(a), où la couche de vernis pelliculable recouvrant l'une des faces de la lame 1, après retrait de celle recouvrant l'autre face, est représentée en 1'.

Dans une deuxième phase, cette face est préparée de façon à recevoir la résine matrice 2 constituant la partie active du filtre. Elle subit un traitement destiné à permettre une bonne adhérence lors du dépôt de la résine matrice. Ce traitement consiste par exemple en un nettoyage avec une solution à 2,5 % de bifluorure d'ammonium, pendant 15 secondes.

La résine est ensuite déposée sur cette face à la tournette, au trempé, au rouleau ou tout autre méthode assurant un dépôt homogène. La résine matrice est une solution d'alcool polyvinylique ou une gélatine rendues sensibles à la lumière d'insolation par incorporation de bichromate d'ammonium. Une fois séché, le dépôt forme une couche d'une épaisseur de 1 à 2 micromètres. A ce stade, l'ensemble se présente comme l'indique la figure 1(b).

Après séchage, la résine est insolée à travers un masque, comme le montre la figure 1(c), où ce masque porte le repère 3. Les flèches représentent, sur cette figure, le rayonnement d'insolation qui arrive par le dessus. Le masque présente des zones transparentes et des zones opaques (traits épais) suivant la géométrie du filtre à réaliser,ici un filtre à bandes. Ce masque est réalisé suivant la technique habituelle en micro-électronique. Après insolation, la résine est dépouillée en milieu aqueux dans ses zones non insolées. Dans l'exemple, on a choisi une résine du type négatif c'est-à-dire une résine devenant insoluble dans ses parties insolées. On obtient ainsi un premier relief de résine constituant une partie du filtre, représenté sur la figure 1(d) ; sur cette figure les carrés sans hachures de la partie supérieure représentent la coupe de la première série de bandes du filtre.

La résine, éventuellement séchée au préalable, est trempée dans un bain de colorant, puis rincée et séchée. La réalisation du premier jeu de bandes est, à ce stade, terminé, comme le montre la figure 1(e) où, après coloration, les-mêmes carrés ont été représentés couverts de hachures. Les colorants sont du type acide, basique ou substantif, solubles dans l'eau.

Avant la réalisation du jeu de bandes suivantes, d'une seconde couleur, et suivant l'une des dispositions de l'invention, le premier jeu de bandes est traité de façon à ne plus accepter les colorations des phases suivantes du procédé. Ce traitement consiste en un tannage qui peut consister en un recuit à 130°C pendant une demi heure ou en un durcissement à la couleur, par action d'acide tannique, de formol..., ou en une exposition à un rayonnement incident X ou gamma ou visible, ou à un faisceau d'électrons.

On réétale ensuite de la résine, par les mêmes procédés que ceux décrits pour la première couche, sur toute la surface du support, en une couche qui recouvre les bandes précédentes. La résine est insolée à travers un nouveau masque qui doit être placé en position convenable par rapport aux bandes déjà réalisées. Ce micro-ajustement des positions se pratique comme en micro-électronique ; il ne pose pas de problème spécifique à l'invention. Les figures 2 montrent la succession de cette seconde série d'opération du procédé de l'invention, à partir de l'état du filtre selon la figure 1(e), le repère 4, figure 2(b), désignant la seconde résine et le repère 3' le second masque, figure 2(c), dont les parties opaques sont disposées en face des premières bandes.

La résine utilisée à ce deuxième stade de la préparation est, elle aussi, du type négatif, c'est-à-dire insoluble dans ses parties insolées. On obtient ainsi l'état de la figure 2(d), après élimination des parties en surépaisseur de la seconde résine et avant coloration, puis celui de la figure 2(e), après coloration de la deuxième série de bandes (hachures indiquées à gauche).

On applique ensuite le filtre sur le photosenseur par ses bandes de résine, et on enlève le verre pelliculable 1'.

Dans ce qui suit sont donnés quelques exemples de mise en oeuvre du procédé de réalisation de l'invention.

Une première série d'exemples concerne la réalisation de filtres à bandes colorées, à deux couleurs, pour photosenseur de caméra de télévision. L'emploi de filtres de deux couleurs pour la prise de vues de télévision se justifie par le fait que, dans certains cas, pour favoriser la couleur verte, on réserve un senseur à cette couleur, un second senseur étant prévu pour les couleurs bleue et rouge. C'est la raison pour laquelle des filtres colorés à deux couleurs seulement peuvent être utilisés en télévision.

On a réalisé dans un exemple un filtre bleu-rouge à bandes de 20 micromètres de largeur, sur un verre pelliculaire, avec comme résine matrice une solution aqueuse d'alcool polyvinylique de Rhône-Poulenc, PVA 14/135, sensibilisée au bichromate d'ammonium. Le dépôt avait une épaisseur de 1,8 micromètre. On le soumettait à un séchage pendant 15 minutes à 50°C. Le verre pelliculaire était muni préalablement sur l'une de ses faces d'une couche anti-halo dans les conditions indiquées plus haut.

Après insolation à la lumière blanche pendant dix secondes à travers un masque au dessin du premier jeu de bandes, la résine était dépouillée à l'eau dans ses zones non insolées. Le dépôt était teint en bleu avec un colorant de la gamme Astrazon de Bayer (Astrazon bleu FRR). Un initiateur était appliqué à la résine préalablement à l'application de colorant. Le rôle de l'initiateur est de favoriser l'imprégnation du matériau de résine par une couleur d'une gamme donnée et de l'inhiber vis-à-vis de tout autre colorant d'une autre gamme. Il s'agissait de l'initiateur Mesitol du même fournisseur ; les deux applications se faisaient par trempage suivi de rinçage et séchage à l'ambiante.

Les bandes rouges étaient réalisées ensuite, dans les mêmes conditions, dans une nouvelle couche de la même résine déposée sur le support par-dessus la première série de bandes. Pour le rouge, le colorant choisi était le Telonecht rot AF 3G de la gamme Telon de Bayer. On terminait la préparation du filtre bicolore par le retrait du film pelliculable. Les différents stades de la préparation sont ceux illustrés sur les figures 2 décrites précédemment.

Une variante de cet exemple de réalisation prévoyait la deuxième insolation à travers les bandes de la première série, utilisées comme masque pour un rayonnement arrivant du côté opposé à celui de la première insolation, comme le montre la figure 3, où ce rayonnement est représenté par les flèches de la partie inférieure de la figure et où les mêmes repères désignent les mêmes éléments que précédemment. Bien entendu, dans ce cas, le vernis pelliculable est retiré avant la deuxième insolation. La réalisation est poursuivie de la même manière que précédemment. Cette variante évite l'emploi d'un second masque et le problème de l'ajustement de sa position.

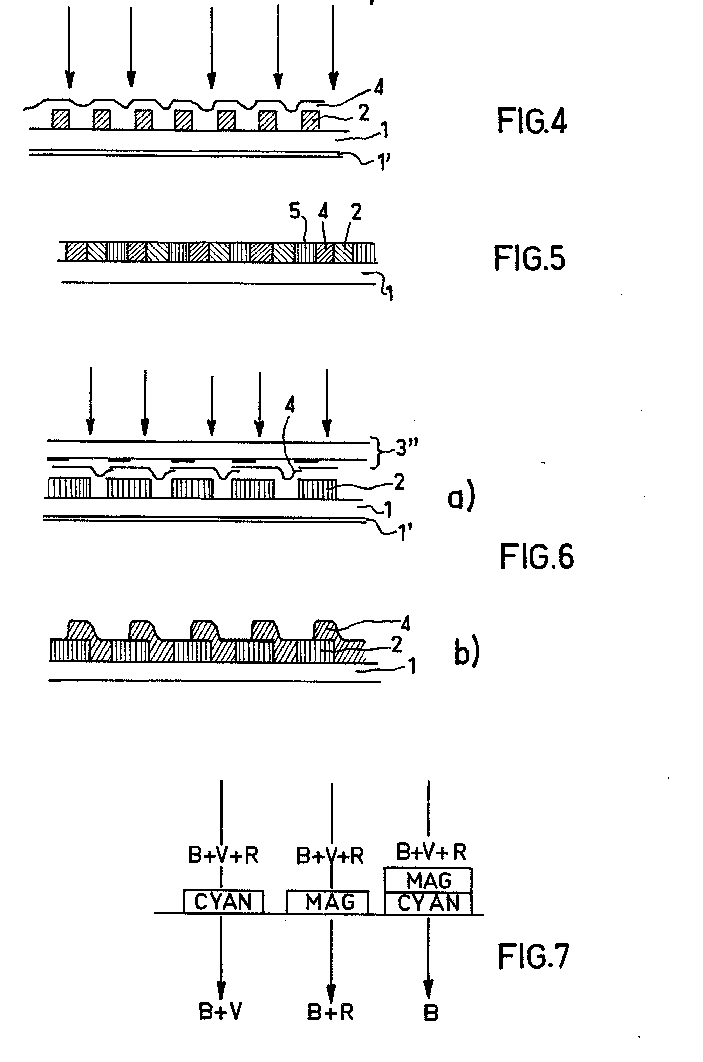

Une importante simplification peut être apportée au procédé décrit plus haut pour la réalisation de filtres bicolores par superposition de deux couleurs sélectionnées et multiplexage des signaux qui leur correspondent ; le bleu et le rouge recherchés seront obtenus par superposition de deux filtres à des couleurs choisies. Dans ce cas la deuxième couche de résine est teintée dans sa totalité. Les conditions de réalisation sont celles décrites ci-dessous, à l'aide de la figure 4.

Après réalisation du jeu de bandes bleues dans les conditions qui ont été décrites, on étend, sur 1 micromètre d'épaisseur sur celles-ci, une solution de gélatine qui, comme dans le cas de la figure précédente, recouvre les bandes et emplit les intervalles entre celles-ci.

La gélatine est la gélatine du type Diamant de la Société Rousselot, sensibilisée au bichromate d'ammonium. Cette dernière couche est insolée, dans sa totalité, par un rayonnement arrivant du même côté que pour l'insolation des bandes bleues, comme le montre la figure. Elle est ensuite teintée, dans des conditions analogues à celles déjà décrites, dans la couleur magenta, à l'aide de l'acide fuschine de la Société Eastmann-Kodak. Exposé au rayonnement de fonctionnement, c'est-à-dire celui de l'image, un tel filtre donne les couleurs bleue et magenta ; par traitement des siguaux de ces deux couleurs, il est possible d'obtenir aussi les signaux correspondant à la couleur rouge.

Une autre série d'exemple concerne la réalisation de filtres à trois couleurs, pour la télévision aussi, notamment ; ces filtres sont utilisés dans le cas où la caméra ne comporte qu'un seul photosenseur.

Les bandes bleues et rouges sont obtenues comme précédemment dans une couche d'alcool polyvinylique et de gélatine ; on y ajoute la réalisation d'un troisième jeu de bandes, 5 dans une troisième résine entre les couples de bandes bleues rouges, à l'aide d'un nouveau masque ou par éclairage de la face arrière, comme expliqué plus haut ; le troisième jeu de bandes est teint en vert par un colorant de la gamme acilane de Bayer (Acilanecht grün 10 G). On obtient le schéma de la figure 5, où l'orientation des hachures permet de distinguer les bandes des trois séries.

On notera que, comme précédemment, par combinaison des réponses spectrales des différentes parties du filtre et multiplexage des signaux, il est possible, dans ce cas, de simplifier le procédé, en réduisant le nombre de masques. Le masque 3" est prévu pour un masquage partiel de la deuxième résine, comme le montre la figure 6(a) ; le résultat est un relief tel que celui représenté sur la figure 6(b).Dans un exemple, la couche 2 d'alcool polyvinylique était alors teintée avec le colorant Cyan de la gamme Levafix de Bayer (Levafix turkisblau E - BA). Le colorant magenta précédent était utilisé pour teinter la seconde couche 4, faite de gélatine. Pour chaque point, on obtenait donc trois zones, à l'endroit des parties des bandes 2 non recouvertes de gélatine, marquées Cyan, à l'endroit des bandes 4 (marquées MAG) comprises entre les bandes bleues précédentes, et à l'endroit où les bandes 4 et les bandes 2 se trou-Vaient superposées. On a représenté, pour la commodité, ces trois zones séparées sur la figure 7, où le rayonnement de fonctionnement est figuré par les grandes flèches marquées des trois couleurs bleu, vert, rouge (BVR), et où les lettres inférieures indiquent le rayonnement filtré par chaque zone.Par traitement des signaux des rayonnements filtrés, il était possible, avec ces deux teintures seulement, d'obtenir les trois couleurs de base.

Dans une autre disposition, contenue dans l'invention, on prévoit une bande blanche, une bande jaune et une bande où sont superposées la couleur jaune et la couleur Cyan ; par bande blanche, on entend une bande exempte de résine ou remplie d'une résine transparente. Les bandes exemptes de résine sont réalisées par exemple en faisant déborder les parties opaques du masque de la figure 6(a) à gauche des bandes 2 ; la couleur jaune est obtenue à l'aide du colorant Brillant Yellow de la Société Eastmann-Kodak.

A l'endroit de la bande blanche, on obtient de la lumière blanche c'est-à-dire notamment les 3 composantes bleu, vert et rouge ; à l'endroit de la bande jaune, les composantes rouge et vert, et à l'endroit de la superposition, le vert. Le multiplexage des signaux des couleurs filtrées par ces bandes permet d'obtenir les trois couleurs de base, Vert, Bleu et Rouge. On notera que, à la place de la couleur Cyan, peut être prévue dans ce cas la couleur verte. On notera également, de façon générale, que dans le cadre de l'invention d'autres séries de couleur peuvent être utilisées à l'obtention des signaux des trois couleurs de base.

Ce qui précède concernant les filtres à trois couleurs à bandes est entièrement transposable aux mosaïques de pavés.

Pour donner une idée des résultats obtenus avec les couples résine-colorant pratiqués dans les exemples cités, on indiquera qu'on atteignait des transmission de 50 % à 70 % avec, par contre, une densité optique de l'ordre de 1,5 pour les couleurs à arrêter.

Toute combinaison des variantes du procédé décrit est également comprise dans l'invention. Par ailleurs, dans le cadre de l'invention, les résines employées pourraient aussi être du type positif, c'est-à-dire rendues solubles par exposition à la lumière.

Enfin les mêmes filtres peuvent être, comme on l'a dit, réalisés "in situ", sur le photosenseur lui-même, utilisé comme support à la place du verre pelliculaire. Dans ce cas, parmi les différentes variantes décrites, seule est à exclure celle qui prévoit deux insolations de directions opposées, l'insolation à travers le photo senseur (figure 3) étant alors généralement imposible.

L'invention s'applique notamment à la prise de vues de télévision en couleurs, à l'aide de caméras à cible à l'état solide. Elle s'applique, plus généralement, à tout composant acceptant le dépôt de tels filtres à sa surface, pour l'analyse ou la synthèse des couleurs.

REVENDICATIONS

1. Procédé de réalisation d'un filtre coloré pour photosenseur recevant en fonctionnement, sur l'une de ses faces, l'image d'un rayonnement, filtre composé de zones colorées, obtenu par insolation et élimination sélective par un solvant de parties de couches de résines (2, 4, 5) appliquées sur cette face, puis teinture des parties restantes par des colorants, à des couleurs déterminées, caractérisé en ce que ces couches de résines sont appliquées directement sur cette face.

2. Procédé suivant la revendication 1, caractérisé en ce que le filtre est préparé sur un support transparent (1), puis appliqué sur cette face du photosenseur.

3. Procédé suivant la revendication 1, caractérisé en ce que le filtre est préparé directement sur cette face du photosenseur jouant le rôle de support.

4. Procédé de réalisation d'un filtre coloré à deux couleurs suivant l'une des revendications 2 ou 3, caractérisé en ce qu'il comprend :

A - l'insolation, à travers un masque (3) comprenant des bandes alternées opaques et transparentes d'une première couche (2) d'alcool polyvinylique recouvrant uniformément le support ;

B - la dissolution en milieu aqueux des bandes non insolées ;

C - la teinture des bandes restantes par un premier colorant d'une gamme donnée ;
puis :

4 - l'application, sur la totalité de la même face du support, d'une couche d'une seconde résine (4), constituée de gélatine, recouvrant les bandes précédentes (2) ;

E - l'insolation de cette deuxième résine au moyen d'un second masque (3'), mis en position sur celle-ci et disposé par rapport à ces bandes (2) de façon que ses parties opaques coïncident avec ces dernières et ses parties transparentes avec les intervalles qui les séparent, par une lumière arrivant du même côté que dans l'opération A) précédente ;

F - dissolution en milieu aqueux de la gélatine dans ses parties non insolées ;

G - teinture de la gélatine avec un second colorant.

5. Procédé suivant la revendication 4, caractérisé en ce que :

a) entre les opérations B) et C) et F) et G), a lieu l'application à la résine d'un initiateur, par trempage par exemple, favorisant son imprégnation par les colorants d'une gamme donnée, et,

b) entre les opérations C) et D), l'application à la résine d'un traitement tannant, l'inhibant vis-à-vis de tout colorant d'une autre gamme.

6. Procédé suivant la revendication 5, caractérisé en ce que le traitement tannant consiste en un étuvage à 130°C pendant 1/2 heure, ou en une exposition à un rayonnement incident X ou gamma ou visible, ou à un faisceau d'électrons de bombardement, ou en une action chimique à l'aide d'un produit tannant, comme le formol.

7. Procédé de réalisation d'un filtre coloré à deux couleurs suivant la revendication 2, caractérisé en ce qu'il comprend ;

- les opérations A, B, C, D suivies de :

E' - l'insolation de cette deuxième résine, par une lumière arrivant du côté opposé à celle de l'opération A) ;

- les opérations F et G.

8. Procédé de réalisation d'un filtre coloré à trois couleurs suivant la revendication 2 ou la revendication 3, caractérisé en ce qu'il comprend :

- les opérations A, B, C, D ;

E" - l'insolation de cette deuxième résine au moyen d'un second masque, mis en place par rapport à ces bandes de façon que ses parties opaques soient contiguës à celles-ci et ses parties transparentes comprises dans les intervalles qui les séparent, par une lumière arrivant du même côté que dans l'opération A) précédente ;

F - dissolution en milieu aqueux de la gélatine dans ses parties insolées ;

G - teinture de la gélatine avec un second colorant ;

- et une troisième série d'opérations comprenant :

H - l'application sur la totalité de la même face du support d'une couche d'une troisième résine (5) recouvrant les bandes précédentes ;

J - l'insolation de cette troisième résine au moyen d'un masque, mis en position par rapport aux deux séries de bandes précédentes de façon que ses parties opaques coïncident avec elles et ses parties transparentes avec les intervalles qui les séparent ;

K - dissolution en milieu aqueux de la troisième résine dans ses parties non insolées ;

L - teinture de la trosième résine avec un troisième colorant, le colorant vert de la gamme Acilane de Bayer (Acilanecht grün 10 G).

9. Procédé de réalisation d'un filtre coloré à trois couleurs suivant la revendication 2, caractérisé en ce qu'il comprend les opérations A, B, C, D, E", F, G, H ;

J' - l'insolation de cette troisième résine par une lumière arrivant du côté opposé à celui des opérations A et E" précédentes,

- les opérations K et L.

10. Procédé de réalisation d'un filtre coloré à deux couleurs suivant la revendication 2 ou la revendication 3, caractérisé en ce qu'il comprend :

- les opérations A, B, C, D, le colorant utilisé dans l'opération C étant le colorant bleu de la gamme Astrazon de Bayer (Astrazon bleu FRR),

- et les opérations :

E'''- insolation de la gélatine dans sa totalité, et

G' - teinture de la gélatine par un colorant de la couleur magenta, à l'aide de l'acide fuschine de la Société Eastmann-Kodak.

11. Procédé de réalisation d'un filtre coloré à trois couleurs suivant la revendication 2 ou la revendication 3, caractérisé en ce qu'il comprend les opérations A, B, C, D, le colorant utilisé dans l'opération C étant le colorant Cyan de la gamme Levafix de Bayer, le Levafix Turkis blau E-BA ;

$E^{iv}$ - l'insolation de cette deuxième résine à travers un second masque 3", mis en position par rapport à ces bandes de manière que ses parties opaques recouvrent partiellement ces bandes au moyen d'une lumière arrivant du même côté que dans l'opération A) précédente ;

F - dissolution en milieu aqueux de la gélatine dans ses parties non insolées ;

G' - teinture de la gélatine par un colorant de couleur magenta à l'aide de l'acide fuschine de la Société Eastmann-Kodak.

12. Procédé de réalisation d'un filtre coloré à trois couleurs suivant la revendication 2 ou la revendication 3, caractérisé en ce qu'il comprend les opérations A, B, C, D, le colorant utilisé dans l'opération C étant le colorant Cyan de la gamme Levafix de Bayer , le Levafix Turkis Blau E-BA ;

$E^{v}$ - l'insolation de cette deuxième résine à travers un second masque, mis en position par rapport à ces bandes de manière que ses parties opaques recouvrent partiellement ces bandes et en débordent d'un côté, au moyen d'une lumière arrivant du même côté que dans l'opération A) précédente ;

F - dissolution en milieu aqueux de la gélaztine dans ses parties non insolées ;

G" - teinture de la gélatine par un colorant de couleur jaune à l'aide du colorant Brillant Yellow de la Société Eastmann-Kodak.

FIG.1

(a)

(b)

(c)

(d)

(e)

FIG.2

(a)

(b)

(c)

(d)

(e)

FIG.3

0065465

2/2

FIG.4

FIG.5

FIG.6

a)

b)

FIG.7

B+V+R    B+V+R    B+V+R

CYAN     MAG     MAG
                 CYAN

B+V      B+R       B

0065465

## 0065465

**Office européen des brevets**

**RAPPORT DE RECHERCHE EUROPEENNE**

Numéro de la demande

EP 82 40 0878

### DOCUMENTS CONSIDERES COMME PERTINENTS

| Categorie | Citation du document avec indication. en cas de besoin. des parties pertinentes | Revendication concernee | CLASSEMENT DE LA DEMANDE (Int. Cl. 3) |
|---|---|---|---|
| Y | JAPANESE PATENTS REPORT, vol. 80, no. 15, 3-9 avril 1980, Section Ch, partie G, page 2, London, GB *Résumé no. JP-B-80 013002* & JP - B - 80 013002 & JP - A - 74 66023 | 1-12 | G 03 C 7/12 H 01 L 31/02 |
| Y | BE-A- 647 415 (POLAROID) *Page 3, ligne 27 - page 4, ligne 15; les revendications* | 1-12 | |
| Y | DE-B-1 075 947 (MONDIA COLOR) *L'exemple; les revendications* & FR - A - 1 237 109 | 1-12 | |
| Y | DE-C- 225 004 (HUTCHINSON) *La revendication* | 5 | |
| A | DE-C- 216 610 (FAUPEL) *La revendication* | 1 | G 03 C 7/00 H 01 L 31/00 |
| A | FR-A- 393 557 (BORREL) *Page 1, ligne 13 - page 2, ligne 27; le résumé* | 1 | |
| D,A | FR-A-2 367 391 (KODAK) | | |

DOMAINES TECHNIQUES RECHERCHES (Int. Cl. 3)

Le present rapport de recherche a ete etabli pour toutes les revendications

| Lieu de la recherche | Date d'achevement de la recherche | Examinateur |
|---|---|---|
| LA HAYE | 28-07-1982 | AMAND J.R.P. |

CATEGORIE DES DOCUMENTS CITES

X : particulierement pertinent à lui seul
Y : particulierement pertinent en combinaison avec un autre document de la même categorie
A : arriere-plan technologique
O : divulgation non-ecrite
P : document intercalaire

T : theorie ou principe à la base de l'invention
E : document de brevet anterieur. mais publie à la date de depôt ou apres cette date
D : cite dans la demande
L : cite pour d'autres raisons

& : membre de la même famille. document correspondant